# EUROPÄISCHE PATENTANMELDUNG

(11) **EP 3 985 467 A1**
(43) Veröffentlichungstag der Anmeldung: **20.04.2022**
(21) Anmeldenummer: 20201982.4
(22) Anmeldetag: 15.10.2020
(51) Int. Cl.: G05B 23/02

(54) **ÜBERWACHUNG EINES STROMRICHTERS**

(71) Anmelder: Siemens Aktiengesellschaft, 80333 München (DE)
(72) Erfinder: Rosca, Cornel-Marian, 92364 Deining (DE); Hecht, Fabian, 91207 Lauf (DE); Kögl, Stefan, 90403 Nürnberg (DE)

(57) **Zusammenfassung**

Bei einem Verfahren zur Überwachung eines Stromrichters (1), werden eine Vielzahl von Warnmeldungen (2) verwendet, um auf einen Fehlerfall des Stromrichters (1) zu schließen. Dabei werden Warnmeldungen (2) gruppiert, wobei die Gruppierung der Warnmeldungen (2) Elementen des Stromrichters (1) entspricht.

## Beschreibung

Die Erfindung betrifft eine Überwachung eines Stromrichters, bzw. die Überwachung eines Antriebes, wobei der Antrieb zumindest einen Stromrichter aufweist, wobei der Antrieb neben einem Stromrichter auch eine elektrische Maschine, wie einen Motor oder einen Generator aufweisen kann.

Durch einen Stromrichter ist es möglich einen drehzahlveränderbaren Betrieb einer elektrischen Maschine, wie zum Beispiel eines Motors, zu realisieren. Ein Stromrichter kann bei einer Anwendung der elektrischen Maschine als Generator auch zur Umwandlung des elektrischen Stromes dienen. Hierdurch kann beispielsweise eine Netzeinspeisung realisiert sein. Für die Anwendung bei einem Motor erfolgt beispielsweise eine Umwandlung der Netzleistung mit konstanter Frequenz und Spannung in eine Leistung mit variabler Frequenz und Spannung. Der Stromrichter ist beispielsweise ein Umrichter, ein Gleichrichter bzw. ein Wechselrichter. Der Stromrichter kann wassergekühlt sein und/oder luftgekühlt sein. Der Stromrichter wird beispielsweise in Anwendungen mit hohen Anforderungen an Zuverlässigkeit und Qualität eingesetzt. Anwendungsbeispiele für Stromrichter sind beispielsweise:
- Industriepumpen oder Lüfter
- Öl- und Gaspumpen und Kompressoren, z.B. elektrische Tauchpumpen und Hochgeschwindigkeitskompressoren
- Kesselgebläse (Saugzug und Druckbelüftung) zur Energieerzeugung
- Reinwasser- und Abwasserpumpen
- Anwendungen mit mehreren Motoren und Synchron-Transfer (z.B. Pipelines in der Öl- und Gasindustrie)
- etc.

Diese Anwendungsbeispiele betreffen insbesondere einen Einsatz des Stromrichters, bei dem insbesondere hohe Leistungen notwendig sind. Dies sind insbesondere Leistungen im einstelligen, zweistelligen oder dreistelligen Megawattbereich. Hierfür sind dann Stromrichter vorzugsweise eingesetzt, welche die Mittelspannung betreffen. Diese sind als Mittelspannungsstromrichter zu bezeichnen. Als Mittelspannung kann eine Spannung von größer, gleich 1000 V angesehen werden. Spannungen von 4000 V oder 6000 V können auch noch als Mittelspannung bezeichnet werden. Der Stromrichter weist beispielsweise neben Leistungshalbleitern, einer Regelung bzw. Steuerung z.B. auch einen Transformator und/oder eine Drossel auf. Der Stromrichter ist beispielsweise ein variable-frequency drive (VFD) .

Wenn der Stromrichter Probleme hat, wird das Problem erkannt und in einer Logdatei dokumentiert bzw. gespeichert. Die Logdatei stellt ein Protokoll dar, wobei die erkannten und dokumentierten Probleme Protokolleinträge sind. Bei diesen Protokolleinträgen kann es sich um Warnungen handeln, um einen Anwender auf potenziell kritische Ereignisse hinzuweisen. Bei diesen Protokolleinträgen kann es sich auch um Fehler, d.h. Fehlermeldungen handeln, um einen Anwender auf einen Fehler hinzuweisen bzw. diesen Fehler zu dokumentieren. Kritische Ereignisse sind also beispielsweise auch Fehler. Für Ereignisse werden also Fehlermeldungen bzw. Warnmeldungen erzeugt. Eine Fehlermeldung kann beispielsweise auch eine Störmeldung sein. Bei einem Fehler liegt also insbesondere eine Störung vor. Fehler können zum Ausfall des Stromrichters und/oder des Antriebs führen bzw. geführt haben. Wenn der Antrieb also beispielsweise Probleme hat, werden erkannte Probleme in Log-Einträgen dokumentiert. Bei diesen Protokolleinträgen kann es sich um Warnungen handeln - um den Anwender auf potenziell kritische Ereignisse hinzuweisen - oder um Fehler - um die Fehler zu dokumentieren, die zum Ausfall des Antriebs geführt haben.

Warnungen, die auf einen suboptimalen Zustand des Antriebs hinweisen, werden derzeit vom Antrieb bzw. dem Stromrichter an eine UI (User Interface) gesendet (z.B. zugänglich über das HMI des Antriebs bzw. des Stromrichters und oder über eine Cloud-Lösung). Die Warnung bzw. die Warnungen werden dann von einem entsprechenden Antriebsexperten analysiert, Maßnahmen sind vom Experten zu treffen und durchzuführen.

Eine Aufgabe der Erfindung ist es die Überwachung des Stromrichters bzw. des Antriebs zu verbessern.

Eine Lösung der Aufgabe ergibt sich nach einem Verfahren nach Anspruch 1 bzw. nach einem Analysesystem nach Anspruch 11. Ausgestaltungen ergeben sich beispielsweise gemäß der Ansprüche 2 bis 10.

Bei einem Verfahren zur Überwachung eines Stromrichters werden eine Vielzahl von Warnmeldungen verwendet, um auf einen Fehlerfall des Stromrichters zu schließen. Dies betrifft hier und im Folgenden neben einem Stromrichter auch einen Antrieb, wobei der Antrieb dem Stromrichter aufweist. Der Antrieb kann neben dem Stromrichter auch ein Getriebe und/oder eine elektrische Maschine aufweisen. Das Schließen auf einen Fehlerfall betrifft die Vorhersage auf einen Fehlerfall. Die Vorhersage des Fehlerfall betrifft also dem Fall, dass der Fehler noch nicht aufgetreten ist aber nach der Vorhersage mit einer bestimmten Wahrscheinlichkeit auftreten wird. Dabei betrifft der Fehler insbesondere auch eine Störung des Stromrichters bzw. des Antriebs.

In einer Ausgestaltung des Verfahrens können Warnmeldungen, also Warnungen beispielsweise folgende Themen betreffen: Temperatur eines Kühlkörpers zu tief, Temperatur eines Kühlkörpers zu hoch, Stromunsymmetrie, Temperatur im Stromrichter zu hoch, Temperatur der Eingangsdrossel hat die Abschaltgrenze fast erreicht, Schrankheizung defekt, Motorheizung defekt, Motor Wicklungstemperatur zu hoch, Isolationsfehler, Schranklüfter ausgefallen, Unterdrehzahl, Motor blockiert und/oder Steuerspannung, etc.

In einer Ausgestaltung des Verfahrens wird ein Ausfall des Stromrichters durch eine algorithmische Analyse von Warnungen vorhersehbar. Warnungen enthalten nicht nur quantitativ messbare Informationen, z.B. durch Schwellenwert-Warnungen, sondern auch qualitative Informationen über den Zustand des Stromrichters bzw. des Antriebs.

In einer Ausgestaltung des Verfahrens werden Warnmeldungen gruppiert, wobei die Gruppierung der Warnmeldungen Elementen des Stromrichters entspricht. So kann es zum Beispiel folgenden Gruppen für Warnungen geben: Transformator, Kühlung, Bypass, Leistungshalbleiter, Zellen, elektrische Maschine, Getriebe und/oder Lager. Derartige Gruppen können bezüglich einer Analyse der Warnmeldungen miteinander verknüpft werden. Warnmeldungen aus unterschiedlichen Gruppen können voneinander abhängen.

In einer Ausgestaltung des Verfahrens können die Warnmeldungen beispielsweise Protokolldaten entnommen werden. Bei der Betrachtung der Warnungen kann in einer Ausgestaltung beispielsweise eine bestimmte Zeitperiode und/oder eine Zeitperiode nach einem Neustart des Stromrichters betrachtet werden. So kann beispielsweise erreicht werden, dass nur relevante Warnmeldungen die in einem zeitlichen Zusammenhang stehen verwendet bzw. betrachtet werden.

In einer Ausgestaltung des Verfahrens ist die Warnmeldungen bzw. sind in die Warnmeldungen gekennzeichnet, also markiert, wobei die Kennzeichnung, also die Markierung, beispielsweise eine zeitliche Abfolge betrifft. Die zeitliche Abfolge ergibt sich beispielsweise durch einen Zeitstempel, der mit einer Warnmeldung verknüpft ist (bzw. umgekehrt). Die Kennzeichnung, also die Markierung, der Warnmeldung kann beispielsweise aber auch eine Dringlichkeit der Warnmeldung sein, die Quelle der Meldung und/oder ein Name (Beschreibung) der Warnmeldung oder dergleichen.

In einer Ausgestaltung des Verfahrens betrifft das Schließen auf einen Fehler eine Vorhersage des Fehlerfalls. Das Schließen auf einen Fehler bedeutet, dass aufgrund von einer oder mehrerer Warnmeldungen, in Kombination oder allein, ein Fehlerfall erwartet wird, falls keine Gegenmaßnahmen getroffen werden. In einer vorteilhaften Ausgestaltung ist die Erwartung des Fehlerfall auch mit einer Zeitangabe verknüpft. Die Zeitangabe geht beispielsweise darüber Auskunft, wann ab einen bestimmten Zeitpunkt (zum Beispiel dem Absetzen der Warnmeldung oder dem Aufruf der Warnmeldung) mit dem Eintreffen eines Fehlers insbesondere mit einer gewissen Wahrscheinlichkeit zu rechnen ist. So kann beispielsweise ermittelt werden, dass mit einer Verlängerung der Zeit des Abwartens die Wahrscheinlichkeit des Eintritts eines Fehlers um einen gewissen Wert steigt.

In einer Ausgestaltung des Verfahrens wird zur Überwachung zumindest eine Regel verwendet, wobei die Regel das Auftreten einer oder mehrerer Warnungen in einer oder mehrerer Gruppen betrifft. So kann beispielsweise das Auftreten von einem oder mehrerer bestimmter Fehler in einer oder mehreren Gruppen miteinander verknüpft werden und analysiert werden.

In einer Ausgestaltung des Verfahrens wird durch eine Analyse der Warnmeldungen eine Meldung für einen bevorstehenden Fehlerfall, also insbesondere für eine bevorstehende Störung generiert. So kann ein Anwender des Stromrichters bzw. des Antriebs Gegenmaßnahmen ergreifen. In einer Ausgestaltung des Verfahrens werden derartige Gegenmaßnahmen durch eine Analyse ermittelt und insbesondere automatisiert eingeleitet.

In einer Ausgestaltung des Verfahrens wird ein Schweregrad eines bevorstehenden Fehlers ermittelt. Abhängig vom Schweregrad können dann geeignete Maßnahmen ergriffen werden. Dies sind zum Beispiel das Planen einer schnellen Reparatur oder das vielleicht etwas langwierigere Bestellen eines Ersatzteils.

In einer Ausgestaltung des Verfahrens ist es möglich eine Vielzahl von Warnmeldungen in eine Meldung für einen bevorstehenden Fehlerfall zu überführen. Dies kann neben einer rechtzeitigen Vorhersage eines bevorstehenden Fehlerfalls beispielsweise auch den Vorteil haben, die Anzahl der für einen Nutzer relevanten Meldungen zu reduzieren. Dies verbessert insbesondere die Übersichtlichkeit und den einfachen Umgang mit dem Stromrichter bzw. Antrieb. Die Meldung für einen bevorstehenden Fehlerfall, der vorzugsweise abwendbar ist, kann beispielsweise mit Precog abgekürzt werden. So kann dieser Begriff beispielsweise als "pre recognition" verstanden werden.

In einer Ausgestaltung des Verfahrens wird eine künstliche Intelligenz verwendet. Auch ist es möglich, gemäß des Verfahrens, die künstliche Intelligenz zu trainieren. So kann durch die künstliche Intelligenz das Wissen eines Experten ersetzt werden.

In einer Ausgestaltung des Verfahrens wird eine Meldung über einen zeitlichen Eintritt des Fehlerfalls erzeugt. Auch ist es beispielsweise möglich zu analysieren, welche weitere Konsequenzen das Auftreten des Fehlers hat. So kann beispielsweise analysiert werden, ob auf Warnmeldungen bzw. eine Meldung über das Bevorstehen eines Fehlers (Precog) vorteilhaft schnell oder langsam zu reagieren ist. Dies kann beispielsweise von einer erwarteten Ausfallzeit abhängig gemacht sein.

Vorteilhaft schnell oder langsam zu reagieren ist 8. Verfahren nach einem der Ansprüche 1 bis 7, wobei eine Meldung über die Verhinderung des Fehlerfalls erzeugt wird.

In einer Ausgestaltung des Verfahrens werden Warnmeldungen über das Internet empfangen. So kann beispielsweise eine Analyseeinrichtung Meldungen von einem Stromrichter bzw. einem Antrieb über das Internet empfangen. Nach der Analyse ist es insbesondere möglich, dass die Analyseeinrichtung Daten bezüglich des Analyseergebnisses an eine Benutzerschnittstelle (UI: unser interface) sendet. Die Benutzerschnittstelle ist beispielsweise über eine Internetverbindung mit derartigen Daten versorgbar. Die Benutzerschnittstelle ist beispielsweise am Ort des Stromrichters bzw. des Antriebs, in einer Leitwarte, etc.

Die Erfindung betrifft neben einem Verfahren auch eine Analyseeinrichtung bzw. ein Analysesystem, welches eine Analyseeinrichtung aufweist. Die Analyseeinrichtung bzw. das Analysesystem ist insbesondere zur Ausführung des Verfahrens ausgebildet. Das Analysesystem kann beispielsweise auch als ein Vorfehlersystems bezeichnet werden, da es potenzielle Fehler vorhersagt, bevor diese auftreten.

Das Analysesystem des Stromrichters bzw. Antriebs weist insbesondere eine künstliche Intelligenz auf, wobei das Analysesystem insbesondere vom Stromrichter örtlich getrennt ist.

In einer Ausgestaltung des Verfahrens bzw. in einer Ausgestaltung des Analysesystems gibt es eine digitale Plattform zur Optimierung von Antriebssystemen, Motoren, Stromrichtern, etc., wobei Meldungen bzw. Logfiles gesammelt und/oder übertragen werden. Es können also Daten vom Stromrichter über das Internet, also über eine Cloud, an ein Analysesystem übertragen werden. Derartige Daten, zum Beispiel eines Logbuchs (Logbuchdaten) werden von einer digitalen Plattform erhalten und enthalten beispielsweise zumindest eine der folgenden Informationen:
- Den Zeitstempel des Log-Ereignisses,
- Die Schwere des Protokollereignisses: Information, Fehler oder Warnung,
- Den Text des Log-Ereignisses,
- Der Akteur des Log-Ereignisses (Generator/Quelle des Log-Ereignisses) .

Ein Ausfall des Antriebs wird beispielsweise durch das Auftreten eines oder mehrerer Fehler nach einer bestimmten fehlerfreien Zeit angezeigt, die zu einem ungeplanten Stillstand des Antriebs führen. Ein Fehler ist insbesondere ein Alarm mit der Schwere "Fehler". Ein Ausfall des Antriebs liegt beispielsweise vor, wenn der Antrieb aufgrund eines oder mehrerer aktiver Fehler einen Stillstand auslöst. Einige Fehler, und damit einige Ausfälle, können durch das Auftreten spezifischer Warnungen, die vor Fehlern auftreten, vorhergesagt werden.

Das Analysesystem ist insbesondere als ein Vor-Fehler-System ausgeführt und analysiert generierte Warnungen mit Hilfe von entwickelten Algorithmen. Das System erkennt also potenziell auftretende Fehler, bevor diese tatsächlich auftreten. Das Analysesystem berücksichtigt insbesondere einen Schweregrad einer Warnmeldung, um eine Vorhersage für das Auftreten eines Fehlers zu erstellen, falls ein potenzieller Ausfall des Antriebs auftreten könnte.

In einer Ausgestaltung des Systems bzw. des Verfahrens erfolgt eine Kategorisierung der Warnungen in mehrere kohärente Gruppen und/oder es erfolgt eine Anwendung spezifischer Entscheidungsregeln auf der Grundlage von Expertenwissen auf diese Gruppen. Beispielsweise können vier Vor-Fehler-Gruppen für Warnungen erstellt sein:
- Eingang/Transformator,
- Zellen, Steuerung, Ausgang,
- Kühlung
- Bypass

Diese Gruppen sind hier beispielhaft genannt. Gruppen decken insbesondere kritische Teile (insbesondere alle kritischen Teile) des Antriebs ab, deren Ausfall über eine Zeitspanne von mindestens mehr als zwei Stunden vorhergesagt werden kann. Wenn spezifische Warnungen bestimmter Gruppen mit einer bestimmten Regel auftreten, gibt das System eine positive Vorhersage für einen potenziellen Antriebsausfall aus der identifizierten Gruppe in Bezug auf eine potenziell kritische Komponente des Antriebs aus.

In einer Ausgestaltung des Systems, weist dieses als Vorfehlersystem spezifische Regeln auf. Dies sind Regeln, von denen es abhängt, ob eine Meldung (Precog) für einen (potenziell) bevorstehenden Fehlerfall zu generieren ist. Hierzu werden beispielsweise Meldungen von der Historie der Protokolle abgezogen und/oder durch weitere Erkenntnisse erweitert.

In einer Ausgestaltung des Analysesystem wird zumindest eine der folgenden Regeln verwendet:
- Regel 1:
   Mindestens 1 Alarm in jeder der Gruppen: Gruppe 1, Gruppe 2, Gruppe 3
- Regel 2:
   Mindestens 1 Alarm in jeder der Gruppen: Gruppe 1, Gruppe 2
- Regel 3:
   Mindestens 1 Alarm in jeder der Gruppen: Gruppe 2, Gruppe 3
- Regel 4:
   Mindestens 3 Alarme in mindestens einer der Gruppen: Gruppe 1, Gruppe 2, Gruppe 3
- Regel 5;
   Mindestens 1 Alarm in der Gruppe 4.

In einer Ausgestaltung des Analysesystems, ist dieses zur Meldung eines bevorstehenden Fehlerfalls ausgeführt, wobei das Analysesystem so ein Vorfehlersystem darstellt, wobei das Analysesystem für eine Meldung zu einem bestimmten Zeitpunkt oder einem bestimmten Zeitraum bestimmt ist, wobei insbesondere nur Warnungen eines bestimmten Zeitraums bei einer Berechnung berücksichtigt werden (z.B. Warnungen, also Warnmeldungen, der letzten 14 Tage (Beispiel für einen Maximalwert). Derartige zeitliche Parameter können an Umstände anpassbar sein. Der Zeitraum ist insbesondere eine charakteristische Zeit, die während der Entwicklung des Stromrichters oder des Antriebs definiert wurde. Dies dient insbesondere dazu, um sicherzustellen, dass nur relevante Warnungen vom Vorfehlersystem berücksichtigt werden. Auch der Zeitstempel einer bestätigten Warnung (Bestätigungszeitstempel) darf in einer Ausgestaltung nicht in der Vergangenheit liegen. Ein Bestätigungszeitstempel markiert das Ende einer aktiven Phase der Warnung. In einer Ausgestaltung des Analysesystems ist der Bestätigungszeitstempel bei der Analyse zu berücksichtigen. Bei der Analyse ist vorteilhaft zu berücksichtigen, ob Warnmeldungen ohne die Durchführung einer Maßnahme (z.B. Reparatur, Austausch, etc.) bestätigt werden oder ob Warnmeldungen nach Durchführung einer Maßnahme bestätigt werden. Hierzu kann sich ein erstes Beispiel wie folgt ergeben: Zwei kritische Warnungen traten in den letzten 24 Stunden nacheinander auf. Die erste Warnung ist Teil von Gruppe 1 und die zweite Warnung ist Teil der Gruppe 2. Das Vorfehlersystem wird aktiviert, wenn die zweite kritische Warnung aufgetreten ist, da hier Regel 2 (siehe oben) angewendet werden kann. Ein zweites Beispiel kann folgendes ergeben: Zwei kritische Warnungen traten in den letzten 24 Stunden nacheinander auf. Beide Warnungen sind Teil der Gruppe 1. Das Vorfehlersystem wird nicht aktiviert, wenn die zweite kritische Meldung aufgetreten ist, da keine Regel hier angewendet werden kann. Wenn danach eine weitere Nachricht der Gruppe 1 eintrifft, dann wird eine Meldung bezüglich eines bevorstehenden Fehlers generiert, da Regel 4 (siehe oben) angewendet werden kann.

Durch das Analysesystem ist es möglich ohne tiefes technisches Wissen, alle Warnungen während der Produktion, also insbesondere während des Betriebs des Antriebs, in Echtzeit zu analysieren. Da die ständige manuelle Analyse sehr zeitaufwendig ist, wurde sie meist nicht in ausreichender Weise in der Produktionsanlage durchgeführt. Das Verfahren liefert automatisch eine Vorhersage für potenziell kritische Situationen, bevor sie eintreten, um den Ausfall zu verhindern. Daher kann die potenzielle Ausfallzeit der Antriebe, zum Beispiel innerhalb einer Produktionsstätte, durch Skalierbarkeit über alle an die Analyseeinrichtung angeschlossenen Antriebe reduziert werden. Im Ergebnis kann beispielsweise zumindest eine der folgenden Funktionen ermöglicht werden:
- man kann sich über einen möglichen Antriebsausfall in naher Zukunft informieren,
- man kann sich darüber informieren, warum ein möglicher Antriebsausfall in naher Zukunft auftreten könnte,
- man kann Empfehlungen und Erklärungen erstellen, um den Ausfall des Antriebs zu verhindern.

In einer Ausgestaltung des Analysesystems ist es möglich mit der Analyseeinrichtung einen Cloud-Analyse-Ansatz zu realisieren, da die Logfile-Daten von dem Antrieb in der Cloud gespeichert werden. Infolgedessen wird das Pre-Fault-System (Vorfehlersystems) auf skalierbaren Cloud-Instanzen in einer geeigneten Python-Umgebung bereitgestellt. Diese technischen Merkmale ermöglichen eine Prozessautomatisierung. Die Methode wird durch Algorithmen implementiert, die auf Expertenwissen basieren.

In einer Ausgestaltung des Verfahrens werden die Logs des Antriebs durch Algorithmen analysiert, die auf Expertenwissen basieren (mit entsprechender Kennzeichnung), die Log-Warnungen in verschiedene kohärente Gruppen klassifiziert und spezifische Entscheidungsregeln auf diese Klassifizierung angewendet, die auch das Auftreten und die Anerkennung/Bestätigung dieser Warnungen berücksichtigen.

Die Merkmale der einzelnen beanspruchten bzw. beschriebenen Gegenstände sind ohne Weiteres miteinander kombinierbar. Im Folgenden wird die Erfindung beispielhaft anhand von Figuren näher dargestellt und erläutert. Die in den Figuren gezeigten Merkmale können fachmännisch zu neuen Ausführungsformen kommbiniert werden, ohne die Erfindung zu verlassen. Gleichartige Elemente erhalten das gleiche Bezugszeichen. Es zeigen
- FIG 1: einen Überblick über das Überwachungsverfahren,
- FIG 2: ein Zeitfenster zu Meldungen,
- FIG 3: eine Wahrheitsmatrix,
- FIG 4: eine Reaktionszeitanalyse,
- FIG 5: eine Statistik,
- FIG 6: ein Ablaufschema,
- FIG 7: eine erste Regeldarstellung,
- FIG 8: eine zweite Regeldarstellung und
- FIG 9: eine dritte Regeldarstellung.

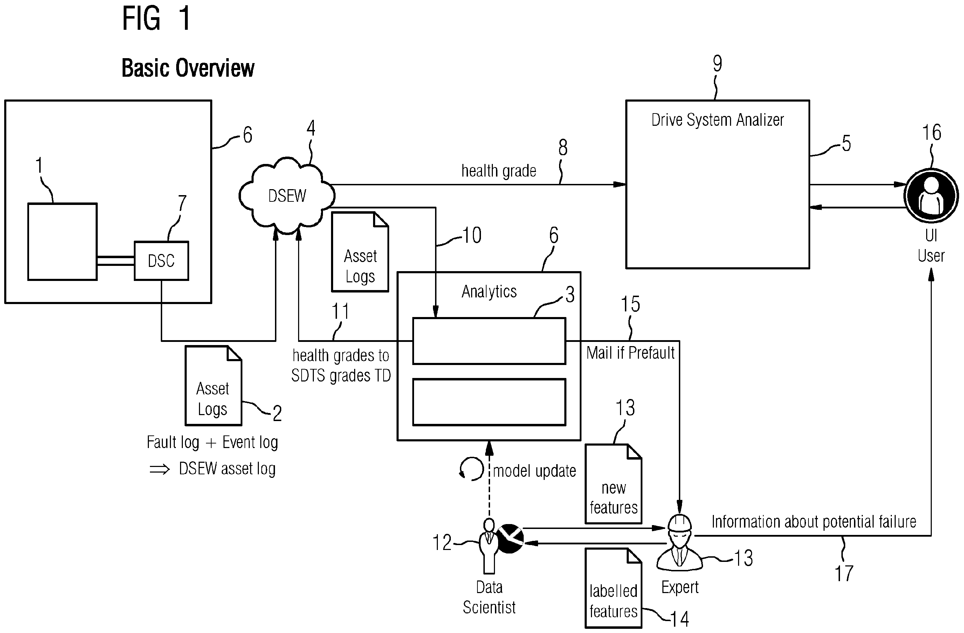

Die Darstellung nach Figur 1 zeigt einen Überblick über ein Überwachungsverfahren. Überwacht ist ein Stromrichter 1. Der Stromrichter 1 ist ein Teil einer Anlage 6. Die Anlage 6 weist ferner eine Kommunikationseinrichtung 7 auf (DSC: Drive System Connect), welche die Kommunikation des Stromrichters 1 ermöglicht. So können Meldungen wie Warnmeldungen (Warnungen) 2 in Logfiles (Logdateien) versandt werden. Derartige Meldungen betreffen beispielsweise Fehler oder allgemein Ereignisse. Derartige Meldungen werden über das Internet 4 versandt. Hierfür kann beispielsweise eine Workstation (DSEW: Drive System Expert Workstation) vorgesehen sein. Hieraus können Informationen über den Gesundheitszustand (health grade) 8 an ein Interface 5 für eine Analysedarstellung 9 des Antriebs versandt werden. Logdaten (Asset Logs) 10 werden auch an ein Analysesystem 6 geschickt, wobei das Analysesystem 6 eine Analyseeinrichtung 3 aufweist. Die Analyseeinrichtung 3 ist beispielsweise mit einer künstlichen Intelligenz versehen. Die Analyseeinrichtung 3 ermittelt einen Gesundheitszustand der Anlage 6 oder einer ihrer Komponenten wie dem Antrieb 1 und sendet diesen Gesundheitszustand 11 an die Workstations 4 im Internet. In dem Analysesystem 6 befindet sich ein Modell. Dieses Modell kann mittels eines Datenanalysten (Data Scientist) 12 verbessert werden, also upgedated werden. Der Datenanalyst 12 kann neue Fehler 13 an einen Experten 13 geben. Der Experte 13 kann bewertete Fehler 14 (labelled failures) zurückgeben. Der Experte 13 erhält beispielsweise eine mail 15, wenn ein zukünftiger Fehler (prefault) 15 ermittelt wurde. Auch so kann der Experte 13 einem Nutzer 16 Informationen über potenzielle Fehler 17 über eine Benutzerschnittstelle (UI) übermitteln.

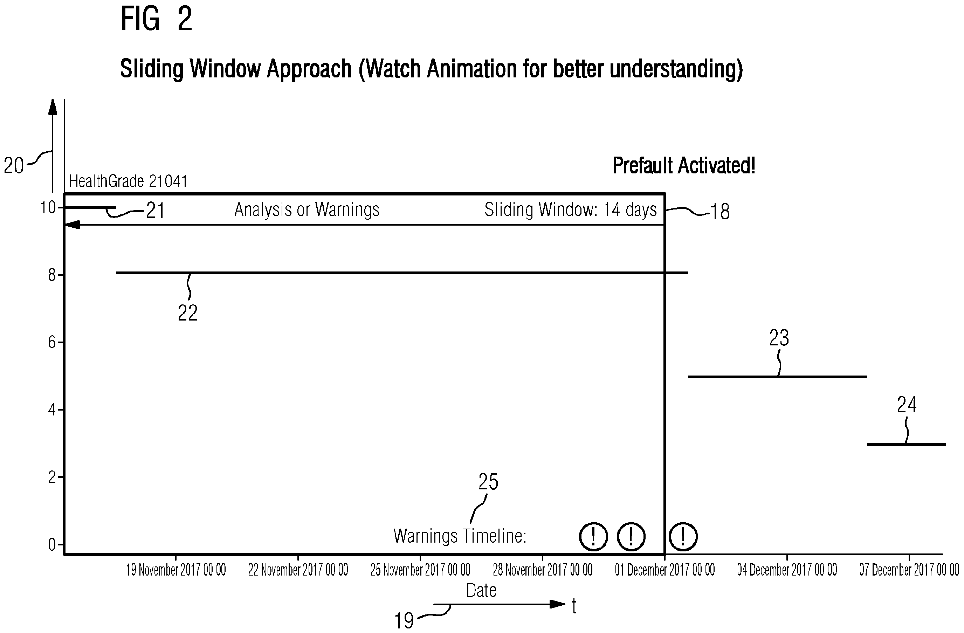

Die Darstellung nach Figur 2 zeigt ein Zeitfenster 18, wobei ein Gesundheitszustand (health grade) 20 über die Zeit 19 aufgetragen ist. Es gibt einen Zustand gesund 21, einen Zustand Warnung 22, einen Zustand für einen bevorstehenden erkannten Fehler (prefault bzw. Precog) 23 und einen Fehlerzustand 24. In dieser Reihenfolge reduziert sich auch der Gesundheitszustand. Das Zeitfenster 18 kann über diese Zustände geführt werden, wobei sich abhängig von den Zuständen ein Zeitstrahl 25 für Warnungen ergibt.

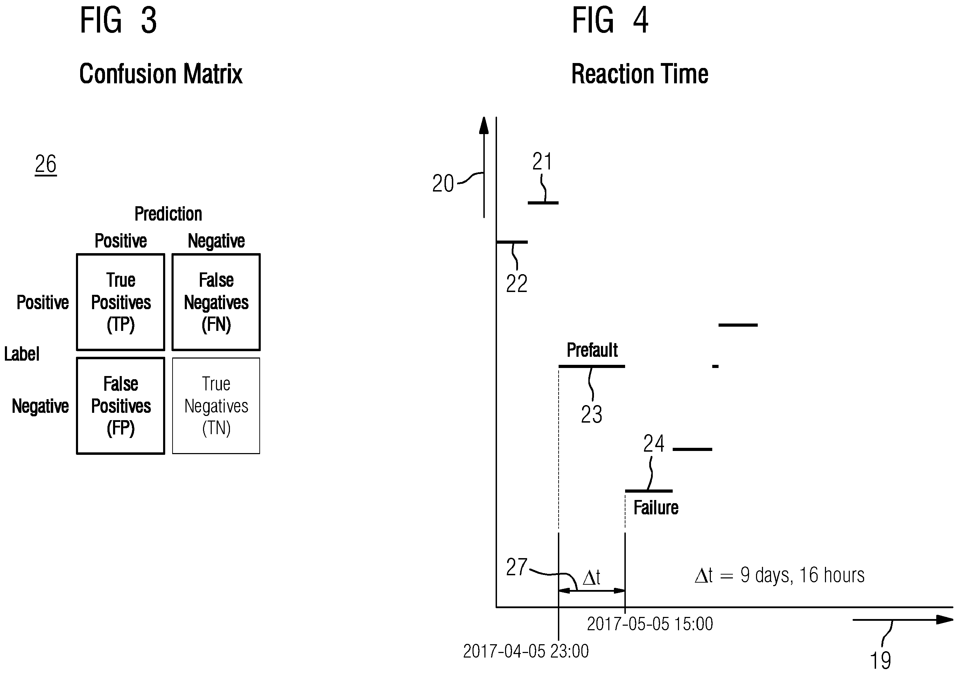

Die Darstellung nach Figur 3 zeigt eine Wahrheitsmatrix (confusion matrix) 26. Diese zeigt, wie eine Vorhersage unter Einbeziehung eines wahren Ereignisses gelabelt, also bezeichnet werden kann.

Die Darstellung nach Figur 4 zeigt die Ermittlung einer Reaktionszeit 27 bis zum Eintritt eines Fehlers 24.

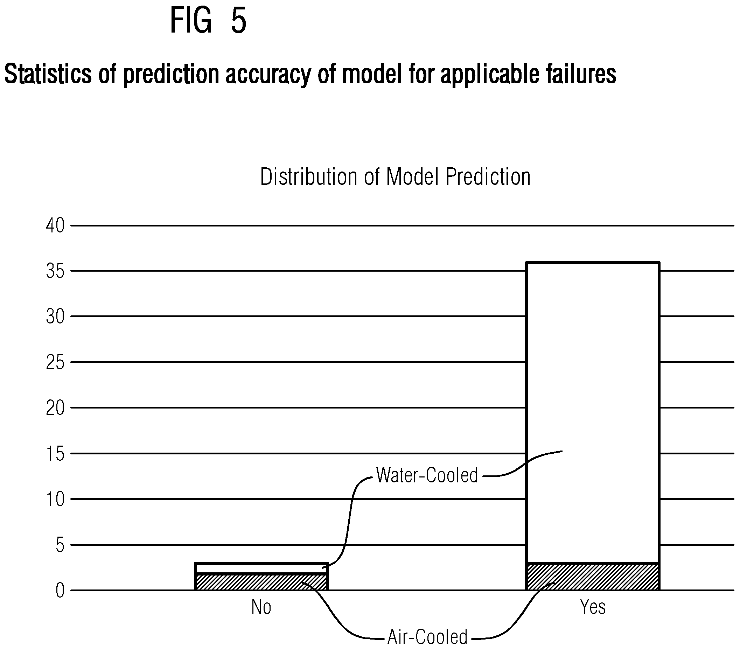

Die Darstellung nach Figur 5 zeigt die statistische Vorhersagegenauigkeit eines Modells zu vorhersagbaren Fehlern. Dabei wird die Verteilung der Modellvorhersage bei Luftkühlung und Wasserkühlung gezeigt.

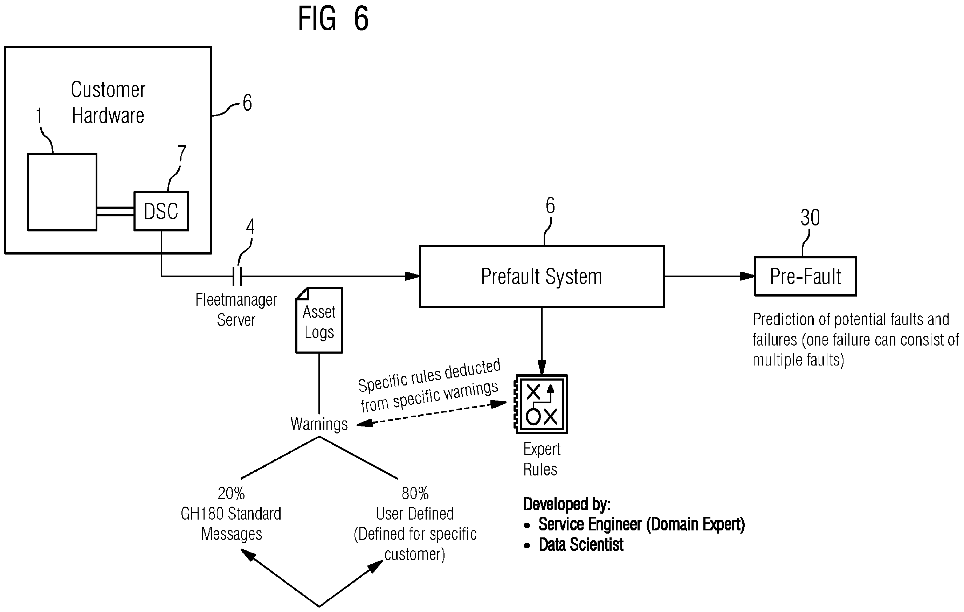

Die Darstellung nach Figur 6 zeigt ein Ablaufschema ähnlich zu Figur 1. Über einen Flotten Manager Server 4, welcher das Internet repräsentiert, werden Daten (Asset logs) des Stromrichters 1 zum Analysesystem 6 geführt. Das Analysesystem 6 führt die Ermittlung der Früherkennung eines Fehlers durch und kann deswegen auch als Prefault System bezeichnet werden. Das Analysesystem 6 gibt eine entsprechende Vorfehlermeldung (Prefault) 30 aus.

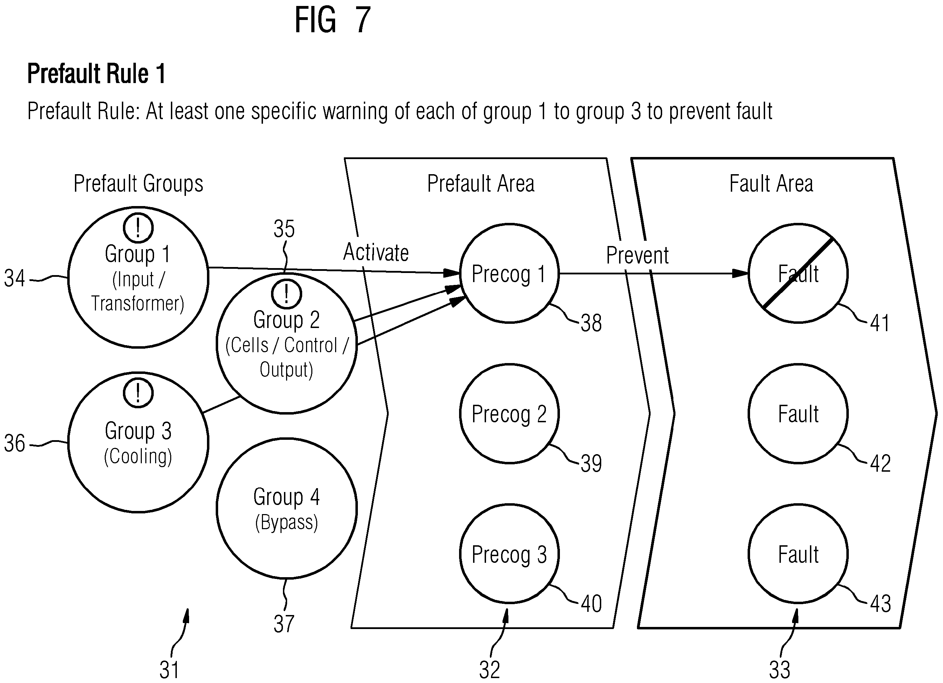

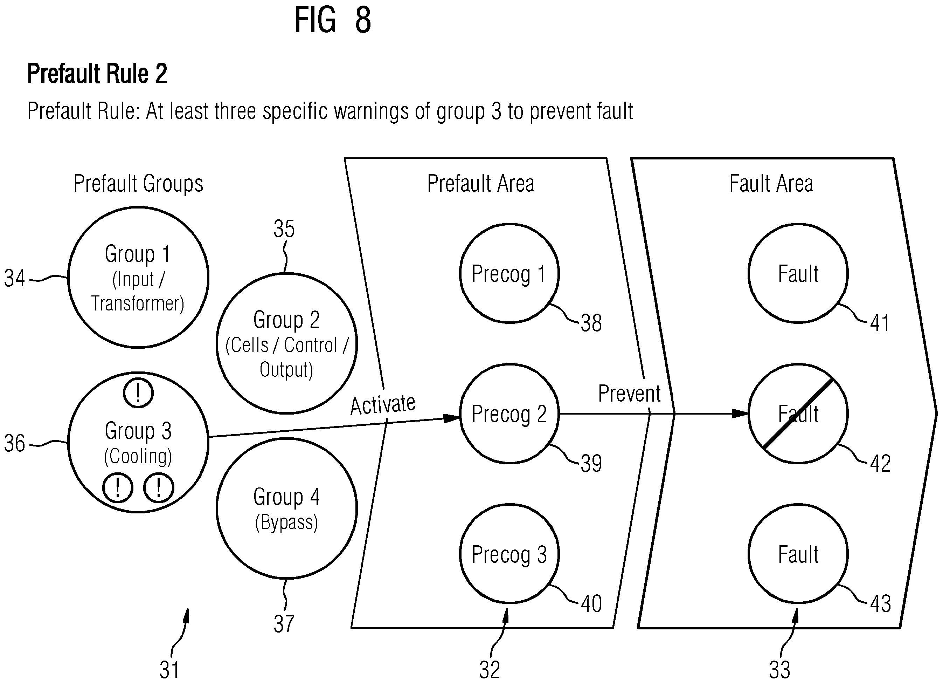

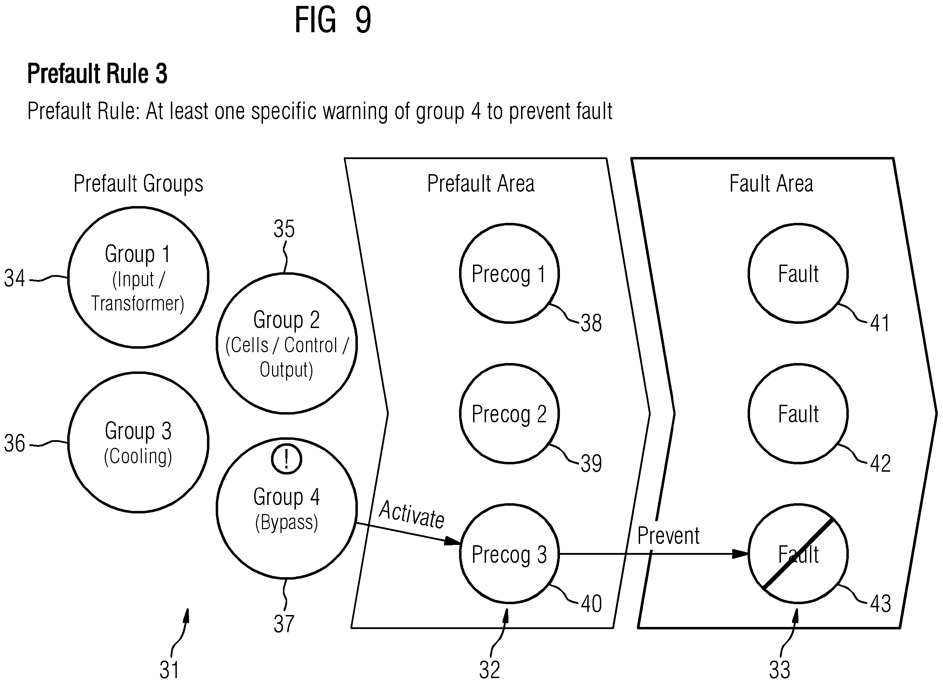

Die Darstellungen nach den Figur 7,8 und 9 zeigen verschiedene Regeldarstellungen. Figur 7 zeigt eine erste Regel. Figur 8 zeigt eine zweite Regel. Figur 9 zeigt eine dritte Regel. Es sind jeweils Bereiche 31, 32 und 33 für die verschiedenen Ereignisse gebildet. Der Bereich 31 betrifft Gruppen 34, 35, 36 und 37 in welchen Warnungen gruppiert sind. In der ersten Gruppe 34 sind Warnungen bezüglich Eingabe und Transformator gruppiert. In der zweiten Gruppe 35 sind Meldungen bezüglich von Zellen des Stromrichters, der Regelung und der Ausgaben gruppiert. In der dritten Gruppe 36 sind Meldungen zu Warnungen bezüglich der Kühlung gruppiert. In der vierten Gruppe 37 sind Meldungen zu Warnungen bezüglich eines Bypasses von Leistungshalbleitern im Stromrichter gruppiert. Nach der ersten Regel hat in den Gruppen 35, 35 und 36 zumindest eine Warnung vorzuliegen um eine Vorfehlerwarnung (Precog 1) 38 zu aktivieren, d. h. auszulösen. So kann ein Fehler 41 verhindert werden. Wie die Darstellungen in den Figuren 7, 8 und 9 zeigen, gibt es im Bereich 32 drei verschiedene Meldungen 38, 39 und 40 zu Warnungen zu einem bevorstehenden Fehler (Precog 1, 2 und 3). Im Bereich 33 für Fehler gibt es drei verschiedene Fehler 41, 42 und 43 wie es vorherzusagen gilt bzw. die zu verhindern sind. Die Darstellung nach Figur 8 zeigt eine zweite Regel, wonach in der dritten Gruppe 36 zumindest drei Warnungen vorzuliegen haben, um die Vorfehlermeldung (Precog 2) 39 zu aktivieren, um den Fehler 42 vorherzusagen, bzw. verhindern zu können. Die Darstellung nach Figur 9 zeigt eine dritte Regel, wonach in der vierten Gruppe 37 zumindest eine Warnung vorzulegen hat, um die Vorfehlermeldung (Precog 3) 40 zu aktivieren, um den Fehler 43 vorherzusagen, bzw. verhindern zu können.

## Patentansprüche

1. Verfahren zur Überwachung eines Stromrichters (1), wobei eine Vielzahl von Warnmeldungen (2) verwendet werden, um auf einen Fehlerfall des Stromrichters (1) zu schließen.

2. Verfahren nach Anspruch 1, wobei Warnmeldungen (2) gruppiert werden, wobei die Gruppierung der Warnmeldungen (2) Elementen des Stromrichters (1) entspricht.

3. Verfahren nach Anspruch 1 oder 2, wobei die Warnmeldungen markiert sind, wobei die Markierung eine zeitliche Abfolge betrifft.

4. Verfahren nach einem der Ansprüche 1 bis 3, wobei das Schließen auf einen Fehler eine Vorhersage des Fehlerfalls betrifft.

5. Verfahren nach einem der Ansprüche 1 bis 4, wobei zur Überwachung eine Regel verwendet wird, wobei die Regel das Auftreten einer oder mehrerer Warnungen in einer oder mehrerer Gruppen betrifft.

6. Verfahren nach einem der Ansprüche 1 bis 5, wobei eine künstliche Intelligenz verwendet wird und/oder trainiert wird.

7. Verfahren nach einem der Ansprüche 1 bis 6, wobei eine Meldung über einen zeitlichen Eintritt des Fehlerfalls erzeugt wird.

8. Verfahren nach einem der Ansprüche 1 bis 7, wobei eine Meldung über die Verhinderung des Fehlerfalls erzeugt wird.

9. Verfahren nach einem der Ansprüche 1 bis 8, wobei Warnmeldungen von einer Analyseeinrichtung (3) über das Internet (4) empfangen werden, wobei eine Analyseergebnis an ein Nutzerschnittstelle (5) gesendet wird.

10. Verfahren nach einem der Ansprüche 1 bis 9, wobei eine Analysesystem (6) nach Anspruch 11 verwendet wird.

11. Analysesystem (6) eines Stromrichters (1), welches insbesondere eine künstliche Intelligenz aufweist, wobei das Analysesystem (6) vom Stromrichter (1) örtlich getrennt ist.
